# EUROPÄISCHE PATENTSCHRIFT

(11) **EP 1 432 125 B1**
(45) Veröffentlichungstag und Bekanntmachung des Hinweises auf die Patenterteilung: **01.08.2007**
(21) Anmeldenummer: 02360362.4
(22) Anmeldetag: 18.12.2002
(51) Int. Cl.: H03K 19/0185

(54) **Ein Konverter von ECL nach CMOS für ein digitales Netzwerk**
ECL-CMOS converter for a digital network
Convertisseur ECL-CMOS pour un réseau numérique

(43) Veröffentlichungstag der Anmeldung: 23.06.2004
(73) Patentinhaber: Alcatel Lucent, 75008 Paris (FR)
(72) Erfinder: Ilchmann, Frank, 13158 Berlin (DE)
(74) Vertreter: Brose, Gerhard

(56) Entgegenhaltungen:
- BE-A- 1 004 501
- PATENT ABSTRACTS OF JAPAN vol. 2003, no. 02, 5. Februar 2003 (2003-02-05) & JP 2002 319857 A (NEC ENG LTD), 31. Oktober 2002 (2002-10-31)
- PATENT ABSTRACTS OF JAPAN vol. 018, no. 603 (E-1632), 16. November 1994 (1994-11-16) & JP 06 232726 A (HITACHI LTD), 19. August 1994 (1994-08-19)
- PATENT ABSTRACTS OF JAPAN vol. 018, no. 467 (E-1599), 30. August 1994 (1994-08-30) & JP 06 152379 A (FUJITSU LTD), 31. Mai 1994 (1994-05-31)
- PATENT ABSTRACTS OF JAPAN vol. 018, no. 675 (E-1648), 20. Dezember 1994 (1994-12-20) & JP 06 268599 A (HITACHI LTD), 22. September 1994 (1994-09-22)

## Beschreibung

Die Erfindung betrifft einen Konverter von ECL nach CMOS nach dem Oberbegriff des Anspruchs 1 und ein Netzwerkelement zum Übertragen von Signalen nach dem Oberbegriff des Anspruchs 5.

Logik-Konverter werden benutzt um unterschiedliche-Logik-Level anzupassen. Ein Eingangssignal wird entsprechend der Logik-Potentialdefinitionen umgesetzt. Der Konverter hat die Aufgabe die Signale mit entsprechender Frequenz zu konvertieren. Solche Signale kommen beispielsweise zwischen aktiven Komponenten innerhalb eines Chips oder zwischen zwei Chips vor. Diese Komponenten können nahe beieinander oder weit auseinender liegen. Beispielsweise können solche Komponenten über einen Bus verbunden sein. Ein weiterer Anwendungsfall ist, wenn die Komponenten in weit voneinander entfernt gelegenen Netzwerkelementen integriert sind.

Signalaustauschende Systeme oder im allgemeinen Telekommunikations-Systeme und -Netze haben das Ziel (elektrische) Signale zuverlässig, fehlerlos und so schnell wie möglich auszutauschen. Um dieses Ziel zu erreichen verwendet man z.B. definierte uniforme Übertragungsraten (Frequenzen) und definierte Amplituden.

Differenzielle Emitter Coupled Logic (ECL) Schaltkreise werden bei der Datenübertrag wegen ihrer höheren Verarbeitungsgeschwindigkeit und ihrer vorteilhaften Signaleigenschaften benutzt. Der differentielle Aspekt dieser Signale mit niedrigen Spannungsniveaus führt beispielsweise zu einem guten Rauschabstand.

Es ist technologisch möglich und wünschenswert ECL-Signale niedrigen Niveaus in Signale höheren Niveaus, wie die der Complementary Metaloxyd Semiconductor (CMOS) Logik-Schaltkreise ohne eine bedeutenden Geschwindigkeitsverlust umzuwandeln, so dass ein solcher Konverter CMOS-Schaltungen ansteuern kann.

Bekannte Konverter von ECL nach CMOS setzen den Pegel auf Kosten von Geschwindigkeits- und/oder Treibereigenschaften um. ECL kann schneller geschaltet werden als CMOS, aber Versuche, die Konvertierung zu beschleunigen vermindern häufig die Ausgangstreibereigenschaften des Stromkreises. Die Schriften US Pat. Nr. 5,726,588 oder US Pat. Nr. 5,426,381 beschreiben Schaltungen mit diesem Nachteil.

Das Konvertieren von ECL-Signalen in CMOS-Signale wird üblicherweise in drei Stufen durchgeführt. Eine Eingangsstufe empfängt und puffert die ECL-Signale, die mit einem Signalhub von wenigen 100mV bezogen auf die positive Betriebsspannung anliegen. Eine Pegelwandlerstufe verschiebt die ECL-Pegel in Richtung der CMOS-Umschaltschwelle und erhöht den Signalhub und eine Ausgangsstufe formt das CMOS kompatible Ausgangssignal.

Eine Konverterschaltung ohne NFET Differenzstufe ist in dem US Patent No. 6,252,421 beschrieben und in der dortigen Figur 1 dargestellt.

Diese Schaltung birgt aber die folgenden Nachteile: Als Pegelwandler wird eine bipolare Differenzstufe 20, ..., 24 verwendet, deren Ausgangssignale dann zum Ansteuern von CMOS-Invertern 25, ..., 28 und 37, ..., 40 benutzt werden. Wird diese Anordnung-mit-niedrigen Betriebspannungen, z.B. unter 3 Volt, betrieben, kann der Ausgangspegel für den Low-Zustand nicht mehr den CMOS-Umschaltpegel, der üblicherweise bei der halben Betriebsspannung liegt, erreichen.

Dies ist durch die Schaltungstechnik des verwendeten Pegelwandlers 20, ..., 24 bedingt. Die Differenzstufe 20, ..., 23 erfordert eine Stromquelle 24, an der typisch 0.8V abfallen. Weiterhin fällt an den Schalttransistoren 22, 23 der Differenzstufe 20, .., 23 eine Spannung in Höhe der Flussspannung ab. Typischerweise sind das ebenfalls etwa 0.8V. Wegen des Sättigungseffektes darf der Kollektor das Basispotential nicht unterschreiten. D.h., der Ausgangspegel für den Low-Zustand kann nicht unter 1.6V sinken. Die CMOS-Umschaltschwelle muss also über 1.6V liegen und damit ergibt sich eine mögliche minimale Betriebsspannung von etwa 1.6V*2 = 3.2V.

Durch eine unsymmetrische Dimensionierung der Inverter 25, ..., 28 und 37, ..., 40, die von der Differenzstufe 20, ..., 23 angesteuert werden, kann diese Spannung noch etwas unterschritten werden. Diese unsymmetrischen Inverter führen aber wiederum zu längeren Schaltzeiten.

Ein weiterer Nachteil der bekannten Lösungen ist auch, dass der Pegelwandler 20, ..., 24 einen relativ großen Signalhub aufweist, da die bipolare Differenzstufe 20, ..., 23 vom minimalen Pegel für den Low-Zustand auf den Pegel der Betriebspannung für den High-Zustand umschaltet. Durch den großen Signalhub ergeben sich relativ lange Umschaltzeiten.

Die Patentpublikation BE 1 004 501 A offenbart eine Konverterschaltung mit einer-Eingangsstufe,-einer Pegelwandlerstufe-und- einer Ausgangsstufe, wobei die Pegelwandlerstufe eine NFET Differenzstufe aufweist.

Ausgehend von dieser Schaltung liegt die Aufgabe zugrunde, differentielle ECL-Eingangsignale in differentielle CMOS-Signale bei niedrigen Betriebsspannungen schnell zu wandeln und dadurch Signale zwischen und in Netzwerkelementen schneller und effizienter zu übertragen.

Diese Aufgabe wird erfindungsgemäß gelöst durch eine Konverterschaltung von ECL nach CMOS, wobei die Eingangsstufe und/oder die Pegelwandlerstufe eine Regelung der Umschaltschwelle hat, und Mittel zur Generierung einer Referenzspannung für Stromquellentransistoren, zur Regelung der Umschaltschwelle umfasst wobei diese Mittel zur Generierung einer Referenzspannung Mittel zur Simulation von der NFET Differenzstufe zur Korrektur der Referenzspannung aufweisen.

Diese Aufgabe wird erfindungsgemäß gelöst durch ein Netzwerkelement das eine solche Konverterschaltung aufweist.

Durch eine NFET Differenzstufe werden die ECL Signale in den Bereich der CMOS Umschaltschwelle gebracht. Diese Form der Ansteuerung arbeitet auch bei niedrigen Betriebsspannungen.

Durch die geringe Anzahl der aktiven Bauelemente wird die Laufzeit der Pegelwandlung stark reduziert. Es werden Laufzeiten unter 200ps erreicht. Die geringe Anzahl der Bauelemente ist auch vorteilhaft, da der Flächenbedarf der Schaltung gering ist.

Insbesondere ist die Schaltung für niedrige Betriebsspannungen (z.B. 2.5V) geeignet.

Weiterhin ist vorteilhaft, dass die Pegelwandlung unempfindlich gegen Schwankungen der Temperatur, Betriebsspannung und Technologieparameter ist. Dadurch wird die Dimensionierung der einzelnen Bauelemente vereinfacht.

Im folgenden wird die Erfindung unter Zuhilfenahme der beiliegenden Zeichnungen weiter erläutert:

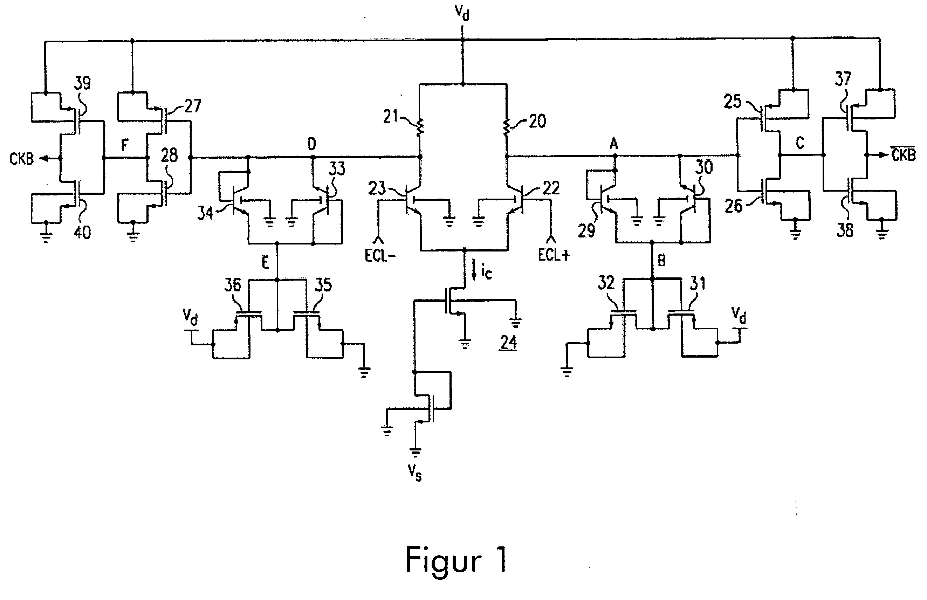

- Figur 1: zeigt einen bekannten Konverter von ECL nach CMOS
- Figur 2: zeigt einen erfindungsgemäßen Konverter von ECL nach CMOS
- Figur 3: zeigt einen erfindungsgemäßen Konverter von ECL nach CMOS mit Regelung der Umschaltschwelle
- Figur 4: zeigt ein Beispiel der Pegelverläufe an einem erfindungsgemäßen Konverter von ECL nach CMOS

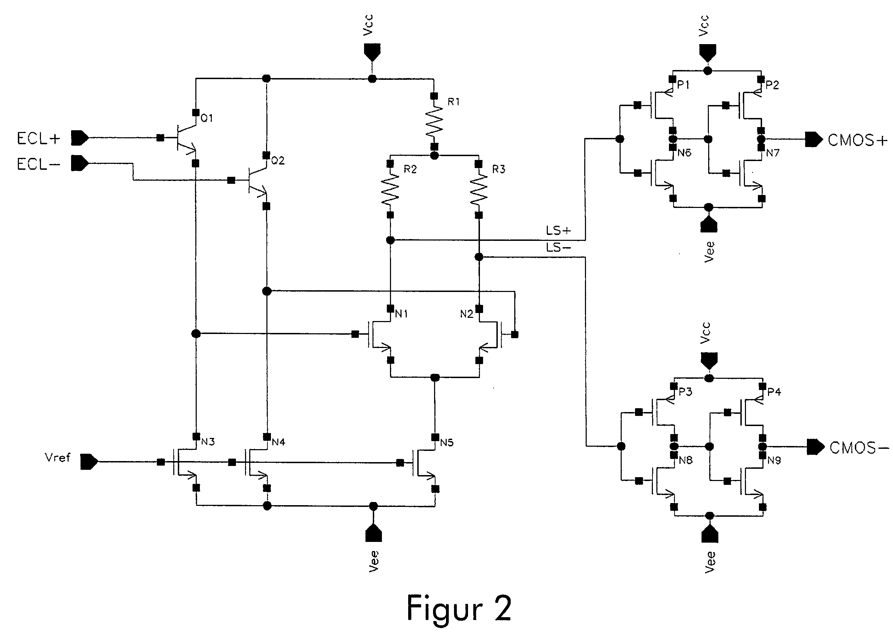

Anhand der Figur 2 wird zunächst die prinzipielle Funktionsweise der Schaltung eines Konverters von ECL nach CMOS erläutert.

Der Konverter von ECL nach CMOS setzt sich aus einer Eingangsstufe, einer Pegelwandlerstufe und einer Ausgangsstufe zusammen. Die Eingangsstufe besteht aus einem Emitterfolger Q1, Q2, N3, N4. Die Pegelwandlerstufe ist eine NFET-Differenzstufe N1, N2, N5, R1, R2, R3. Die nachfolgende Ausgangsstufe setzt sich aus CMOS-Invertern P1/N6, P2/N7, P3/N8, P4/N9 zur Impulsformung zusammen.

Durch die Verwendung von NFETs N1 und N2 in der Differenzstufe kann der Ausgangspegel für den Low-Zustand wesentlich tiefer liegen als bei einer bipolaren Lösung, da bei FETs das Drainpotential unter dem Gatepotential liegen darf.

Weiterhin wird der Signalhub der Differenzstufe N1, N2, N5, R1, R2, R3 durch den Widerstand R1 verringert.

Die Dimensionierung dieses Pegelwandlers ist so, dass bei vorgegebenem Strom durch den Pegelwandler (durch Vref bestimmt) der Pegel für den High-Zustand durch den Spannungsabfall an R1 bestimmt ist und der Pegel für den Low-Zustand durch den Spannungsabfall an R1 und R2 oder R3 bestimmt ist. Die Differenzstufe ist so ausgebildet, dass die Transistoren bei einem definiertem ECL-Eingangssignal an der Eingangsstufe entweder durchgeschaltet oder gesperrt sind.

In der Differenzstufe ist dann abhängig von den Gatepotentialen entweder N1 oder N2 leitend. Ist z.B. N1 (durch ein höheres Gatepotential als an N2) eingeschaltet, fließt der Strom durch R1, R2, N1 und N5. Das Drainpotential LS+ von N1 hat dann Low-Potential (Spannungsabfall an R1 und R2) und das Drainpotential LS- von N2 hat dann High-Potential (nur Spannungsabfall an R1, da durch R3 kein Strom fließt). Die durch R1 und R2/R3 eingestellten Pegel sollten symmetrisch zur Umschaltschwelle der angesteuerten CMOS Inverter P1/N6, P3/N8 sein um ein schnelles Umschalten zu erreichen.

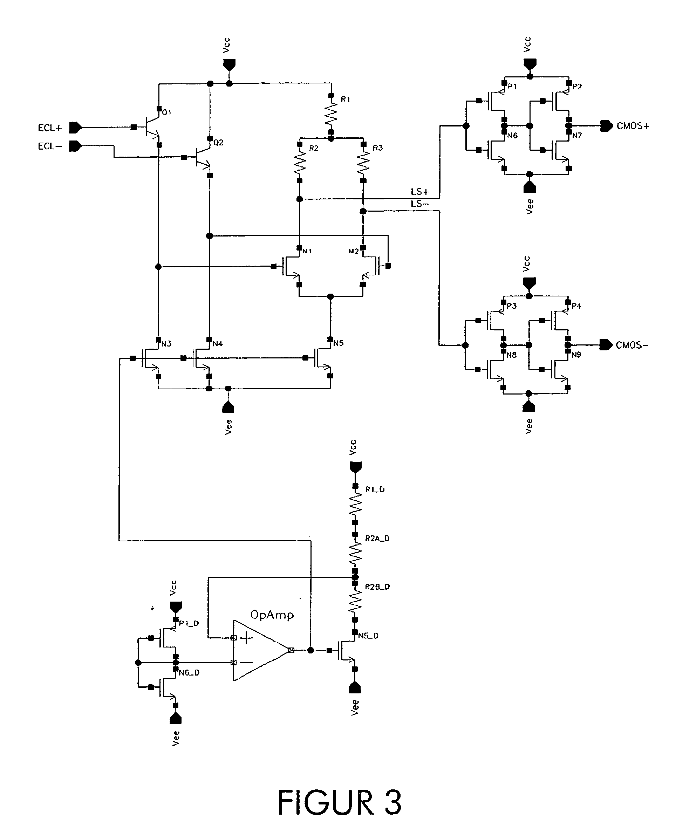

In der ECL-Technologie lassen sich kürzere Umschaltzeiten durch erhöhen der Ströme in den Differenzstufen erreichen. Dies hat den Nachteil, dass sich dadurch auch die Verlustleistung erhöht und sich das beispielsweise nachteilig auf die Integrationsdichte und Leistungsaufnahme auswirkt. Anhand der Figur 3 wird erläutert wie ein Konverter von ECL nach CMOS mit zusätzlicher Regelung der Umschaltschwelle eine weitere Verringerung der Umschaltzeit ohne Erhöhung der Verlustleistung ermöglicht.

Durch eine Verringerung des Signalhubs der Differenzstufe N1, N2, N5, R1, R2, R3 wird die Umschaltzeit verringert ohne die Verlustleistung zu erhöhen. Um bei einem reduzierten Signalhub eine sichere Funktion des Konverters auch bei Schwankungen von Temperatur, Betriebsspannung und Technologieparametern zu gewährleisten, wird die Referenzspannung an den Stromquellentransistoren N3, N4, N5 geregelt. Dabei wird die Umschaltschwelle der CMOS Inverter als Regelnormal verwendet.

Dieses Regelnormal wird von einem Operationsverstärker OpAmp mit einer künstlich erzeugten Spannung verglichen, die der Mitte des Signalhubs der Differenzstufe entspricht. Die Regelung besteht aus dem Operationsverstärker OpAmp, einer Nachbildung oder Dummy P1_D, N6_D des CMOS Inverters P3, N8 oder P1, N6 und einer Nachbildung R1_D, R2A_D, R2B_D, N5_D der Differenzstufe N1, N2, N5, R1, R2, R3. In der Nachbildung der Differenzstufe hat R1_D den gleichen Wert wie R1 und N5_D hat die gleiche Dimensionierung wie N5. Der Widerstand R2 der Differenzstufe wurde in zwei gleich große Widerstände R2A_D und R2B_D aufgeteilt. Die Spannung zwischen den Widerständen R2A_D und R2B_D der Nachbildung R1_D, R2A_D, R2B_D, N5_D der Differenzstufe N1, N2, N5, R1, R2, R3 entspricht genau der Mitte des Signalhubs zwischen LS+ und LS-.

Die Schaltschwelle der CMOS Inverter P1, N6 oder P3, N8 wird durch einen Kurzschluss der Nachbildung P1_D, N6_D des CMOS Inverters erzeugt. Der Operationsverstärker OpAmp zieht über die Regelung des Stromes durch N5_D das künstliche Mittenpotential in der Nachbildung der Differenzstufe auf die Schaltschwelle des CMOS Inverters.

Da die Widerstände und NFETs von der Nachbildung und der Differenzstufe gleich sind, stellen sich in der originalen Differenzstufe die gleichen Pegel ein. Dadurch sind die Ausgangspegel der Differenzstufe immer auf die Schaltschwelle der CMOS Inverter zentriert.

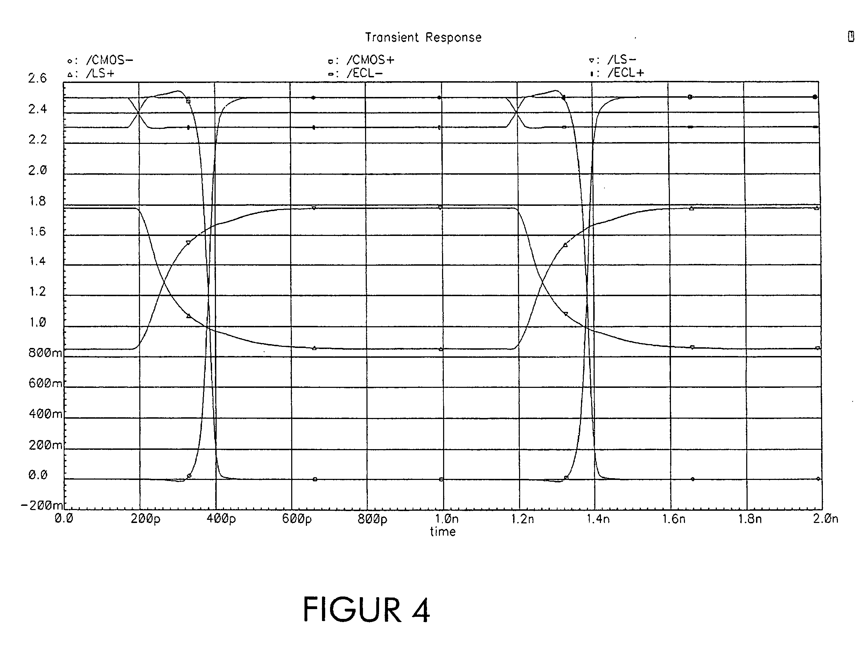

Figur 4 zeigt die Pegelverläufe am ECL/CMOS Pegelwandler für eine Betriebsspannung von 2.5 Volt. ECL+/ECL- sind die differentiellen ECL Eingangsignale mit einem Signalhub von 200mV, LS+/LS- sind die Ausgangsspannungen des Pegelwandlers und CMOS+/CMOS- zeigt die CMOS Ausgangssignale.

## Patentansprüche

1. Konverter von ECL nach CMOS mit einer Eingangsstufe (Q1, Q2, N3, N4), einer Pegelwandlerstufe (N1, N2, N5, R1, R2, R3) und einer Ausgangsstufe (P1, P2, P3, P4, N6, N7, N8, N9), wobei die Pegelwandlerstufe (N1, N2, N5, R1, R2, R3) eine NFET Differenzstufe (N1, N2) aufweist, wobei die Eingangsstufe (Q1, Q2, N3, N4) und/oder die Pegelwandlerstufe (N1, N2, N5, R1, R2, R3) eine Regelung der Umschaltschwelle hat und wobei der Konverter Mittel zur Generierung einer Referenzspannung für Stromquellentransistoren (N3, N4, N5) zur Regelung der Umschaltschwelle umfasst, **dadurch gekennzeichnet, dass** die Mittel (P1_D, N6_D, OpAmp, N5_D, R1_D, R2A_D. R2B_D) zur Generierung einer Referenzspannung eine Nachbildung (P1_D, N6_D, N5_D, R1_D, R2A_D. R2B_D) von der NFET Differenzstufe (N1, N2) zur Korrektur der Referenzspannung aufweisen.

2. Ein Netzwerkelement zum Übertragen von Signalen, **dadurch gekennzeichnet, dass** das Netzwerkelement einen Konverter von ECL nach CMOS noch Anspruch 1 umfasst.

## Claims

1. An ECL to CMOS converter having an input stage (Q1, Q2, N3, N4), a level shifter stage (N1, N2, N5, R1, R2, R3), and an output stage (P1, P2, P3, P4, N6, N7, N8, N9), the level shifter stage (N1, N2, N5, R1, R2, R3) comprising an NFET differential stage (N1, N2), the input stage (Q1, Q2, N3, N4) and/or the level shifter stage (N1, N2, N5, R1, R2, R3) comprising a switching-threshold control system, and the converter comprising means for generating a reference voltage for current-source transistors (N3, N4, N5) to control the switching threshold, **characterized in that** the means (P1_D, N6_D, OpAmp, N5_D, R1_D, R2A_D, R2B_D) for generating a reference voltage comprise a simulating network (P1_D, N6_D, N5_D, R1_D, R2A_D, R2B_D) for the NFET differential stage (N1, N2) to correct the reference voltage.

2. A network element for transmitting signals, **characterized in that** it comprises an ECL to CMOS converter according to claim 1.

## Revendications

1. Convertisseur ECL/CMOS comprenant un étage d'entrée (Q1, Q2, N3, N4), un étage convertisseur de niveau (N1, N2, N5, R1, R2, R3) et un étage de sortie (P1, P2, P3, P4, N6, N7, N8, N9), l'étage convertisseur de niveau (N1, N2, N5, R1, R2, R3) présentant un étage différentiel NFET (N1 ? N2), l'étage d'entrée (Q1, Q2, N3, N4) et/ou l'étage convertisseur de niveau (N1, N2, N5, R1, R2, R3) comprenant une régulation du seuil de commutation et le convertisseur englobant des moyens pour générer une tension de référence pour les transistors de source de courant (N3, N4, N5) en vue de réguler le seuil de commutation, **caractérisé en ce que** les moyens (P1_D, N6_D, OpAmp, N5_D, R1_D, R2A_D, R2B_D) pour générer une tension de référence présentent une simulation (P1_D, N6_D, N5_D, R1_D, R2A_D, R2B_D) de l'étage différentiel NFET (N1, N2) pour corriger la tension de référence.

2. Élément de réseau pour transmettre des signaux, **caractérisé en ce que** l'élément de réseau comprend un convertisseur ECL/CMOS selon la revendication 1.
